Europäisches Patentamt

(19) European Patent Office

Office européen des brevets

(11) Numéro de publication: **0 217 691**
**A1**

# (12) DEMANDE DE BREVET EUROPEEN

(21) Numéro de dépôt: **86401807.2**

(22) Date de dépôt: **13.08.86**

(51) Int. Cl.4: **G 11 C 27/02**
**H 04 N 3/15**

(30) Priorité: **20.08.85 FR 8512528**

(43) Date de publication de la demande:
**08.04.87 Bulletin 87/15**

(84) Etats contractants désignés: **DE GB**

(71) Demandeur: **THOMSON VIDEO EQUIPEMENT**
**17, rue du Petit Albi**
**F-95800 Cergy Saint Christophe (FR)**

(72) Inventeur: **Eouzan, Jean-Yves**
**THOMSON-CSF SCPI 19, avenue de Messine**
**F-75008 Paris (FR)**

**Claverie, Claude**
**THOMSON-CSF SCPI 19, avenue de Messine**
**F-75008 Paris (FR)**

**Heurtaux, Jean-Claude**
**THOMSON-CSF SCPI 19, avenue de Messine**
**F-75008 Paris (FR)**

(74) Mandataire: **Lincot, Georges et al**
**THOMSON-CSF SCPI 19, avenue de Messine**
**F-75008 Paris (FR)**

(54) **Dispositif échantillonneur-bloqueur à pont de diodes.**

(57) Le dispositif échantillonneur-bloqueur selon l'invention comprend un amplificateur d'entrée ($A_1$), un étage d'échantillonnage à pont de diodes SCHOTTKY ($D_1$ - $D_4$) et de mémorisation analogique comprenant un condensateur ($C_M$), un amplificateur de sortie ($A_2$) et un étage de commande à liaisons continues constitué par un amplificateur différentiel symétrique à transistors ($Q'_1$, $Q'_2$) montés en émetteurs couplés.

Application notamment à l'échantillonnage de signaux vidéo délivrés par des capteurs d'images matriciels à transfert de charges.

Fig.11

EP 0 217 691 A1

## Description

<center>Dispositif échantillonneur-bloqueur à pont de diodes</center>

La présente invention concerne un dispositif échantillonneurbloqueur à pont de diodes, en particulier à pont de diodes SCHOTTKY, notamment pour des applications dans le domaine du traitement de signaux vidéo. Plus particulièrement, l'application visée concerne les circuits associés à un circuit capteur d'image photo-sensible matriciel à transfert de charges utilisé dans une caméra de télévision.

Un dispositif photosensible à transfert de charges comporte une matrice d'éléments photosensibles sur laquelle est projetée la lumière d'une image pour créer dans chaque élément une charge électrique qui est proportionnelle à l'éclairement reçu et à la durée d'accumulation de ces charges. Il comporte également une matrice d'éléments mémoires où sont transférées ces charges pour y être stockées en attendant d'être évacuées vers une sortie pour générer un signal vidéo. Parmi les dispositifs photosensibles connus, on distingue plusieurs types de dispositifs et notamment les dispositifs à transfert de trame. Dans le cas d'un dispositif photosensible dit à transfert de trame, ces deux matrices sont distinctes, l'accumulation des charges a lieu pendant la durée d'une trame, le transfert a lieu pendant l'intervalle entre l'analyse de deux trames et l'évacuation des charges a lieu pendant la durée de l'analyse de la trame suivante. Le déplacement des charges, pour leur transfert et leur évacuation, est commandé par des champs électriques appliqués au moyen d'un réseau d'électrodes surmontant les éléments photosensibles et les éléments mémoires.

Ce dispositif comporte donc un certain nombre d'organes élémentaires de types synchrones, commandés par des impulsions d'horloges. Les fréquences de ces impulsions sont en relation de dépendance avec les fréquences de balayage de lignes et de points à l'intérieur d'une ligne.

Le dispositif comprend un registre de sortie évacuant les charges enregistrées dans la zone mémoire. Le signal de sortie de ce registre va être utilisé pour générer le signal vidéo représentant une image projetée sur le dispositif photosensible. Il est issu d'une conversion de type charge-tension.

Dans la réalité, il s'agit d'un signal composite comportant un signal utile de type impulsionnel, d'amplitude variable selon les conditions d'éclairement, mixé à des signaux parasites, également de type impulsionnel, notamment des signaux dûs à des couplages parasites avec des impulsions d'horloges à la fréquence du balayage points.

Le signal utile a typiquement une amplitude de l'ordre de 700 mV pour un éclairement proche de la saturation du dispositif photosensible et pouvant descendre jusqu'à 2 mV pour un blanc, à bas niveau de lumière.

Par contre, le signal parasite à la fréquence horloge a une amplitude typique de 200 mV crête à crête quels que soient le niveau d'éclairement et, donc, l'amplitude du signal utile.

Dans les conditions extrêmes de basse luminosité, il est nécessaire d'amplifier le signal utile pour pouvoir l'exploiter. Aussi, il est d'usage de prévoir un amplificateur d'un gain typique de l'ordre de dix.

Le signal parasite est également amplifié, de sorte que le problème demeure d'extraire la partie utile d'un signal qui comporte une partie parasite d'amplitude cent fois plus importante.

Il est donc nécessaire d'opérer un échantillonnage et de mémoriser l'amplitude du signal utile échantillonné. Cette mémorisation doit s'effectuer pendant des temps relativement longs. Enfin l'intervalle de temps pendant lequel le signal utile est présent est très court, de l'ordre de quelques dizaines de nanosecondes. Il est donc nécessaire que l'acquisition s'effectue en un temps inférieur, par exemple en utilisant des impulsions d'échantillonnage de l'ordre de 10 ns.

Toutes ces caractéristiques imposent des contraintes sévères pour la réalisation d'un dispositif échantillonneur-bloqueur permettant l'acquisition et la mémorisation des signaux utiles dans l'application préférentielle qui vient d'être rappelée.

On connaît des dispositifs échantillonneurs-bloqueurs à pont de diodes SCHOTTKY comprenant un étage amplificateur, un étage échantillonneur comportant le pont des diodes SCHOTTKY suivi d'une mémoire analogique, et un étage amplificateur de sortie. Cependant dans les dispositifs de ce type, il est prévu un étage de commande comportant des liaisons soit capacitives, soit selfiques par utilisation de transformateurs. Ils ne peuvent convenir pour l'application rappelée, car ils ne satisfont pas simultanément à toutes les exigences soulevées, notamment un temps d'acquisition court, un temps de maintien long et un faible résidu de parasite d'échantillonnage.

L'invention vise à satisfaire les besoins évoqués.

Selon une des caractéristiques essentielles du dispositif selon l'invention, il est prévu un circuit de commande différentiel à liaison continue, circuit commandant le pont des diodes SCHOTTKY par des impulsions de commandes complémentaires.

L'invention a donc pour objet un dispositif échantillonneurbloqueur comprenant, connectés en cascade, un premier étage amplificateur recevant un signal à échantillonner sur son entrée, un étage d'échantillonnage et de mémorisation analogique du signal de sortie du premier étage amplificateur et un second étage amplificateur, l'étage d'échantillonnage et de mémorisation analogique comprenant un pont de diodes comportant deux branches parallèles de diodes disposées tête-bêche, connectées entre une borne d'entrée recevant le signal de sortie du premier étage amplificateur et une borne de sortie connectée d'une part, à l'entrée du deuxième étage amplificateur et, d'autre part, à un organe de mémorisation analogique, caractérisé en ce qu'il comprend des circuits de commande d'échantillonnage à liaisons continues

<center>2</center>

comprenant des premier et second générateurs de tension de même polarité reliés chacun, d'une part à des première et seconde bornes constituées chacune par le point commun entre deux diodes tête-bêche de chacune des branches du pont et, d'autre part, à une borne commune à un potentiel de référence, un générateur de courant constant et des moyens de commutation commandés par des signaux impulsionnels d'échantillonnage présentant des premier et second niveaux, ces moyens de commutation connectant le générateur de courant constant à la première borne du pont de diodes pendant un premier intervalle de temps, lorsque les signaux d'échantillonnage sont au premier niveau, et à la seconde borne dans le cas contraire, de manière à commander la conduction du pont de diodes par des signaux impulsionnels complémentaires et la recopie de l'amplitude des signaux présents sur la borne d'entrée dans l'organe de mémorisation analogique pendant le premier intervalle de temps.

L'invention sera mieux comprise et d'autres avantages et particularités apparaîtront à la lecture de la description qui suit à la lumière des dessins annexés et parmi lesquels :

- la figure 1 représente schématiquement un dispositif photosensible bi-phasé à transfert de trame;
- la figure 2 est un exemple de signal fourni en sortie d'un tel dispositif;
- la figure 3 illustre schématiquement l'architecture d'un dispositif échantillonneur-bloqueur;
- la figure 4 est un exemple de réalisation d'un étage amplificateur d'entrée pour un tel dispositif;
- les figures 5 à 10 illustrent différents aspects du fonctionnement du dispositif selon l'invention;
- la figure 11 est un exemple de réalisation d'un circuit de commande d'échantillonnage pour un tel dispositif;
- la figure 12 est un exemple de réalisation d'un étage amplificateur de sortie pour un tel dispositif.

Il semble tout d'abord utile de rappeler brièvement les principales caractéristiques d'un dispositif photosensible à transfert de charges qui constitue un cadre d'application préférentielle de la présente invention.

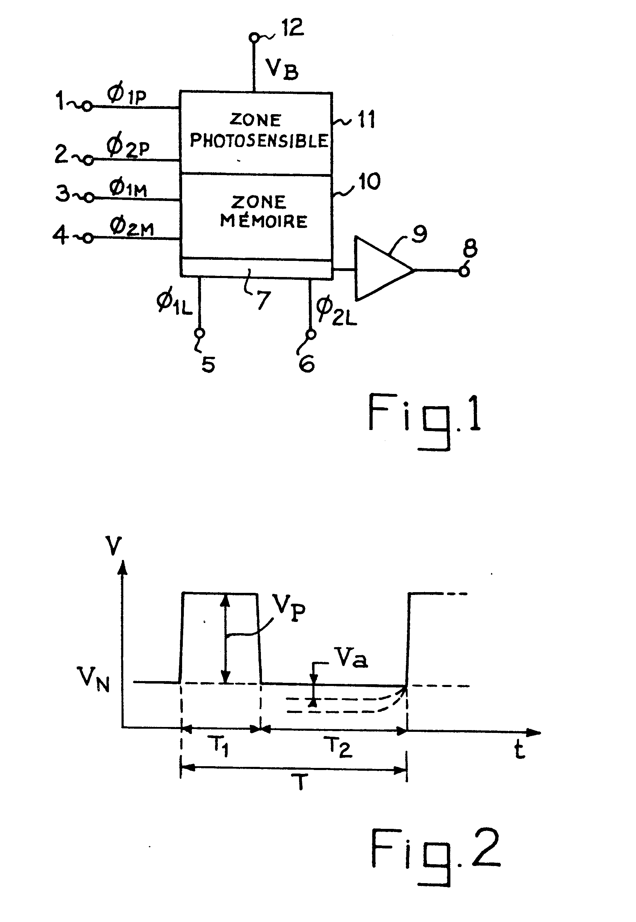

La figure 1 représente un schéma synoptique d'un dispositif photosensible, par exemple du type THX 1138 commercialisé par la société de droit français THOMSON-CSF, permettant d'analyser une trame d'image en 288 lignes comportant chacune 208 points élémentaires. Il fonctionne selon le principe du transfert de trame, les transferts étant réalisés au moyen de deux horloges déphasées.

Sur la figure 1, ce dispositif comporte trois zones: une zone photosensible 11 constituée d'une matrice de 288 lignes comportant chacune 208 éléments photosensibles, d'une zone mémoire 10 constituée d'une matrice comportant le même nombre d'éléments mémoires et un registre de sortie 7 connecté à un amplificateur de sortie 9 extérieur. La zone photosensible 11 a une face connexe à une face de la zone mémoire 10, face à travers laquelle est réalisé le transfert des charges pendant un intervalle de temps correspondant à l'intervalle inter-trames du signal vidéo fourni par le dispositif photosensible.

La zone photosensible 11 possède trois bornes d'entrée 1, 2 et 12 recevant respectivement un signal d'horloge $\Phi_{1P}$, un signal d'horloge $\Phi_{2P}$, et une tension continue de polarisation de drains anti-éblouissement, de valeur $V_B$ par rapport au substrat, dont est pourvu le dispositif.

La zone mémoire 10 possède deux bornes d'entrée 3 et 4, recevant respectivement des signaux d'horloge $\Phi_{1M}$ et $\Phi_{2M}$ déphasés. La zone mémoire 10 possède une seconde face qui est connexe au registre de sortie 7, dans lequel les charges sont transférées par paquet correspondant à une ligne. Le registre de sortie 7 possède deux bornes d'entrée 5 et 6 recevant respectivement des signaux d'horloge $\Phi_{1L}$ et $\Phi_{2L}$ déphasés, et une sortie reliée à l'entrée d'un amplificateur de sortie 9. L'amplificateur de sortie 9 est relié à une borne de sortie 8 fournissant un signal vidéo.

Une image est projetée par un système optique sur la zone photosensible 11. Les photons de l'éclairement procuré par cette image créent des paires électron-trou dans les éléments photosensibles de la zone 11. Des charges s'accumulent dans ces éléments proportionnellement à l'éclairement reçu et à sa durée. Dans cet exemple le temps d'intégration est égal à la durée d'analyse d'une trame, 20 ms, moins le temps nécessaire au transfert des charges vers la zone mémoire, environ 1 ms. Lorsque le dispositif photosensible est utilisé classiquement, pendant la durée de l'accumulation les signaux d'horloge $\Phi_{1P}$ et $\Phi_{2P}$ ont une valeur constante telle que la polarisation des éléments photosensibles permette l'accumulation des charges dans ces éléments. Pour analyser des trames paires et des trames impaires entrelacées, ces valeurs constantes sont permutées d'une trame à la suivante pour procurer un décalage, correspondant à un demi-élément dans la direction verticale, des éléments photosensibles où s'accumulent les charges.

Pendant l'intervalle inter-trame les signaux d'horloge $\Phi_{1P}$, $\Phi_{2P}$, $\Phi_{1M}$, et $\Phi_{2M}$ reçoivent des impulsions déphasées dont le nombre correspond au nombre de lignes des matrices de la zone photosensible 11 et de la zone mémoire 10, pour transférer les charges de la zone 11 à la zone 10. Pendant l'analyse de la trame suivante, c'est-à-dire l'accumulation de nouvelles charges dans la zone photosensible 11, les charges de la zone mémoire 10 sont transmises dans le registre 7 par paquets correspondant à une ligne, en appliquant des impulsions d'horloge $\Phi_{1M}$ et $\Phi_{2M}$, déphasées entre elles, et dont le nombre correspond au nombre de lignes de la matrice de la zone mémoire 10. Le contenu du registre de sortie 7 est transféré vers l'amplificateur 9 sous l'action des signaux d'horloge $\Phi_{1L}$ et $\Phi_{2L}$, qui sont déphasés entre eux, et dont la fréquence correspond au rythme d'analyse des éléments d'image.

Le signal de sortie du registre 7 amplifié par l'amplificateur 9 à l'allure représentée schématiquement par la figure 2.

L'axe vertical du diagramme de la figure 2 représente l'amplitude du signal et l'axe horizontal est l'axe des temps.

3

Le signal présent sur la borne 8 a une période T de 133 ns. Il comporte un signal impulsionnel parasite à flancs raides, d'amplitude $V_P$ très importante, au-dessus d'une valeur $V_N$ correspondante au niveau du noir.

Comme il a été indiqué, l'amplitude de ce signal parasite peut atteindre 2V ou plus. Cette impulsion dure 33 ns: intervalle de temps $T_1$. L'intervalle de temps $T_2$ entre deux impulsions parasites est de 100 ns.

Pendant cet intervalle de temps le signal utile a une amplitude $V_u$ extrêmement variable selon l'éclairement, pouvant aller de 20 mV à quelques volts. C'est ce type de signal qu'il faut amplifier et échantillonner dans l'application principale de l'invention, avec les difficultés que cela comporte.

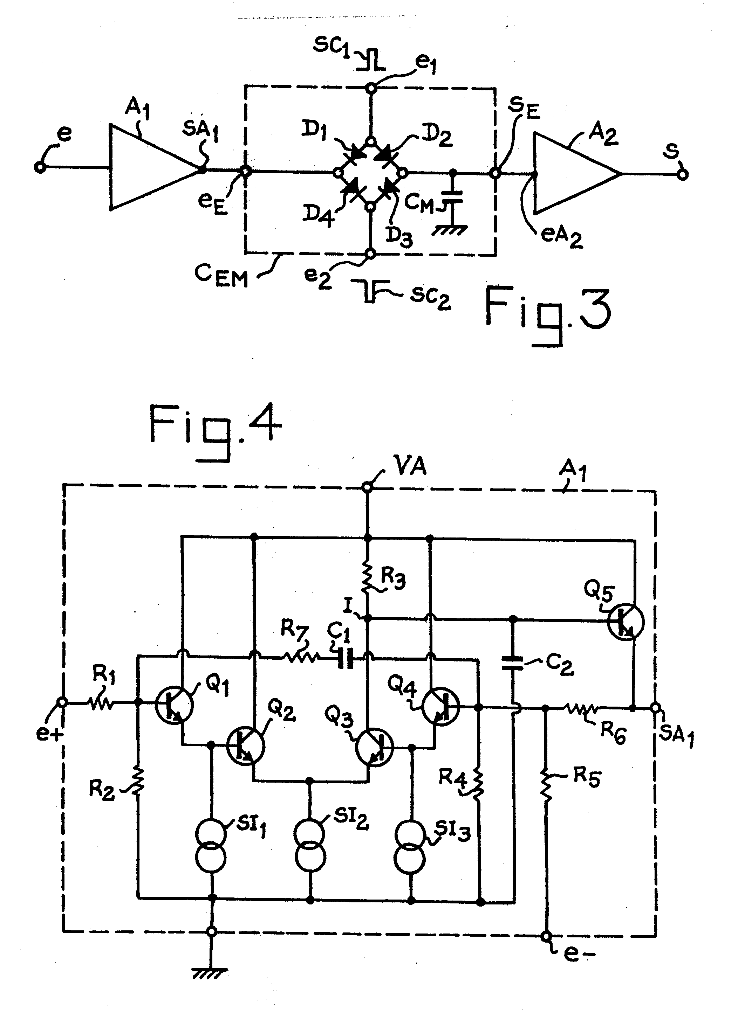

La figure 3 illustre schématiquement l'architecture générale d'un dispositif échantillonneur-bloqueur.

Le dispositif d'échantillonnage-blocage comporte un amplificateur d'entrée $A_1$ jouant le rôle d'interface entre une source, non illustrée, délivrant un signal vidéo transmis à l'entrée e et le pont de diodes SCHOTTKY $D_1$ à $D_4$, d'un étage d'échantillonnage proprement dit, $C_{EM}$, afin d'optimiser l'attaque du pont de diode quelles que soient les caractéristiques de la source délivrant le signal d'entrée.

La configuration du dispositif, en soi, est commune à celle des dispositifs de l'art connu. Des dispositions spécifiques à l'invention seront détaillées dans le cours de la description.

Notamment, dans le cadre de l'invention, en ce qui concerne l'amplificateur d'entrée $A_1$, les caractéristiques principales sont les suivantes:
- entrée différentielle;
- bande passante élevée:
- bruit très faible;
- impédance de sortie très faible, optimisée pour attaquer le pont de diodes SCHOTTKY $D_1$ à $D_4$.

La sortie $SA_1$ de cet amplificateur $A_1$ est directement reliée au pont de diodes $D_1$ à $D_4$ par l'entrée $e_E$, pont qui reçoit ou délivre les informations suivantes:
- Borne d'entrée $e_E$: entrée du signal vidéo;
- Borne d'entrée $e_1$: impulsion d'échantillonnage et maintien $SC_1$
- Borne d'entrée $e_2$: impulsion complémentaire d'échantillonnage de sortie $S_E$ et maintien $SC_2$;
- Borne de sortie $S_E$: sortie du signal vidéo échantillonné.

Les bornes $e_1$ et $e_2$ du pont de diodes SCHOTTKY $D_1$ à $D_4$ reçoivent donc deux impulsions complémentaires, respectivement $SC_1$ et $SC_2$, pour commander l'ouverture et la fermeture de l'échantillonneur bloqueur.

La borne de sortie $S_E$ est également connectée à une capacité $C_M$ de mémorisation de l'information analogique et à l'entrée $eA_2$ haute impédance de l'amplificateur de sortie $A_2$.

Cet amplificateur doit présenter une impédance d'entrée très élevée de façon à maintenir l'information analogique mémorisée dans la capacité $C_M$ le plus longtemps possible sans altération.

Le rôle et les caractéristiques des différents sous-ensembles constituant l'échantillonneur bloqueur seront mieux compris à partir de l'étude détaillée qui va suivre.

La figure 4 illustre le synoptique d'un exemple de réalisation simplifiée de l'amplificateur d'entrée $A_1$.

L'étage d'entrée de l'amplificateur $A_1$ est constitué par un circuit amplificateur différentiel comportant quatre transistors $Q_1$ à $Q_4$ agencés deux par deux de façon à fournir une structure super $\beta$. Le but de ce différentiel à structure super $\beta$ est de réduire au maximum le courant de base des transistors d'entrée de façon à minimiser le bruit propre de l'étage d'entrée.

Les transistors $Q_1$ à $Q_4$ sont, dans l'exemple illustré, des transistors bipolaires de type NPN.

Les transistors $Q_1$ et $Q_4$ commandent par leurs émetteurs les bases des transistors $Q_2$ et $Q_3$, ces derniers étant couplés par leurs émetteurs.

L'amplificateur $A_1$ est alimenté par une source de tension fournissant une tension continue VA par rapport au potentiel de la terre.

A l'exception du transistor $Q_3$ dont le collecteur est relié à une borne d'alimentation de potentiel VA via une résistance de charge $R_3$, les transistors $Q_1$, $Q_2$ et $Q_4$ ont leur collecteur directement relié à cette borne de potentiel VA.

L'émetteur du transistor $Q_1$ est relié à la terre par une source de courant $SI_1$; l'émetteur du transistor $Q_4$ est relié à la terre par une source de courant $SI_3$ et les émetteurs des transistors $Q_2$ et $Q_3$ y sont reliés par une source de courant commune $SI_2$.

Bien qu'il ait été représenté sur la figure 1 une entrée unique e, en réalité l'amplificateur $A_1$ comporte deux entrées: une entrée directe e + et une entrée inverseuse e-.

On peut donc, à convenance, inverser ou non le signal d'entrée du fait de la structure différentielle , ce qui est intéressant dans de nombreux cas.

Chaque entrée est munie d'un pont diviseur d'adaptation de niveau disposé entre la borne d'entrée et le potentiel de la terre: les résistances $R_1$ et $R_2$ pour l'entrée e + et les résistances $R_5$ et $R_4$ pour l'entrée e-. les bases des transistors $Q_1$ et $Q_4$ sont reliées aux points milieux de ces ponts. Enfin, l'amplificateur $A_1$ comprend un étage de sortie à un transistor bipolaire de type NPN: $Q_5$.

Le collecteur de ce transistor est relié à la borne d'alimentation de potentiel VA et sa base est reliée au point I. point de connexion entre la résistance de charge $R_3$ et le collecteur du transistor $Q_3$.

Le gain en boucle fermé est défini par un réseau de contreréaction inséré entre la sortie $SA_1$ et l'entrée e- de l'amplificateur. Dans l'exemple illustré, ce réseau comprend une résistance $R_6$.

Le contrôle de la bande passante de l'amplificateur $A_1$ est obtenu par un compromis entre le pôle engendré par une capacité $C_2$ disposée entre le point I et la terre et un réseau comprenant en série une capacité $C_1$ et

une résistance $R_7$ reliant les bases des transistors $Q_1$ et $Q_4$.

On peut évidemment contrôler la bande passante en augmentant la valeur de la capacité $C_2$, mais cela s'effectue au détriment de la réponse dynamique de l'amplificateur $A_1$ car il faut pouvoir charger et décharger très rapidement cette capacité, ce qui nécessiterait une augmentation prohibitive du courant collecteur du différentiel. Une dissipation prohibitive et une augmentation du courant base engendrent une augmentation du bruit.

D'un autre côté, le contrôle de la bande passante ne saurait s'effectuer uniquement par le réseau $R_7 C_1$, car cela conduit généralement à une très faible valeur pour la résistance $R_7$ induisant aussi un bruit important.

Le produit "Gain × Bande" d'un tel amplificateur peut atteindre des valeurs élevées.

En effet, le gain en boucle ouverte $G_0$ est sensiblement égal à:

$$\text{à : } \frac{R_3}{\tau_2 + \tau_3}$$

relation dans laquelle $\tau_2$ et $\tau_3$ représentent les résistances dynamiques d'émetteur des transistors $Q_2$ et $Q_3$.

La bande passante BP en boucle ouverte est en général limitée par le pôle engendré par le réseau $R_3$, $C_2$, où $C_2$ représente la somme des capacités au point I, le choix des éléments permettant de rejeter les autres pôles à des fréquences supérieures à la bande passante.

Le produit "Gain × Bande": $G_0 \times B$, devient ainsi:

$$G_0 \times B = \frac{1}{2\pi(\tau_2 + \tau_3)C_2}$$

Pour fixer les idées, des valeurs typiques des différents paramètres sont:

$\tau_2 + \tau_3 = 20\Omega$

$C_2 = 5$ pF

d'où "$G_0 \times B$" = 1600 MHz

Les éléments $R_4$, $R_5$ et $R_6$ permettent d'optimiser le gain de l'amplificateur et sa tension moyenne en sortie pour réaliser l'adaptation entre le signal d'entrée et le circuit d'échantillonnage proprement dit.

Le dimensionnement précis de ces éléments ainsi que celui des autres éléments et le choix des types de transistors dépend naturellement de l'application envisagée et est à la portée de l'homme de métier.

La sortie $SA_1$ de l'amplificateur $A_1$ est reliée à l'entrée $e_E$ des circuits $C_{EM}$, d'échantillonnage et de maintien.

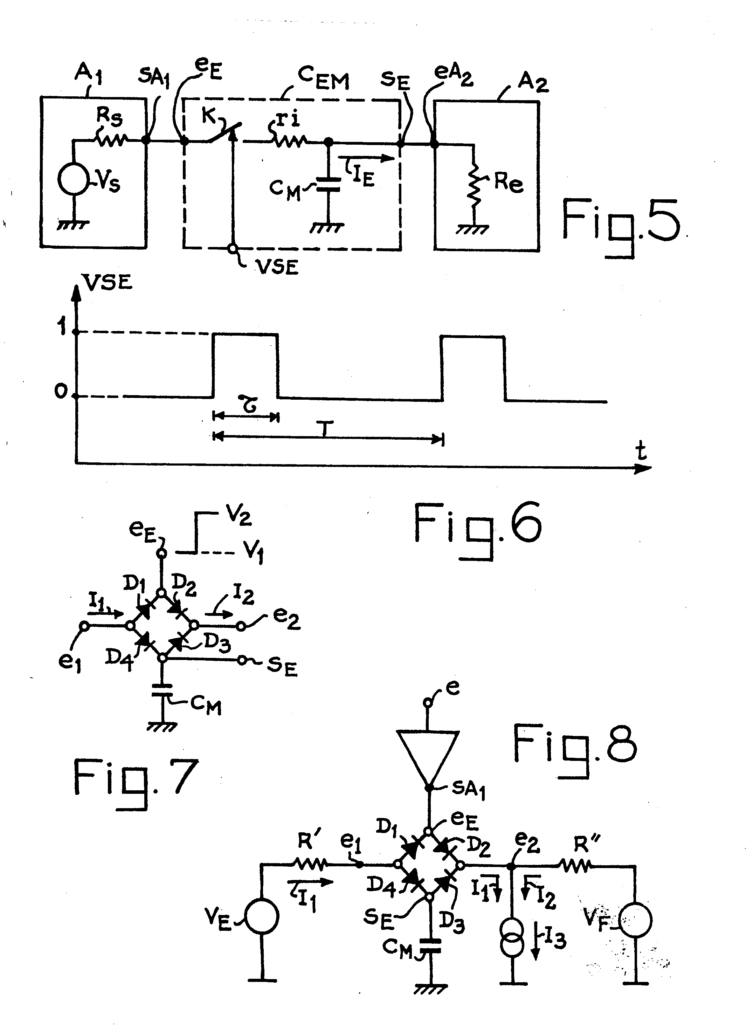

Un circuit d'échantillonnage et maintien est illustré par le schéma équivalent représenté sur la figure 5.

Les symboles $V_s$ et $R_s$ représentent respectivement le générateur de tension délivrant le signal et la résistance de sortie de l'amplificateur d'entrée $A_1$, $r_i$ représente la résistance interne du circuit échantillonneur, $C_M$ la capacité mémoire et $I_E$ le courant de fuite de l'amplificateur de sortie vers l'impédance d'entrée $R_e$ de l'amplificateur $A_2$.

L'échantillonnage est commandé par un signal de commande VSE agissant sur une commutateur K. Un tel signal est représenté par le diagramme de la figure 6 où $\tau$ traduit la durée de l'échantil lonnage et T la récurrence de l'échantillonnage. Le commutateur K (figure 5) est fermé durant la période $\tau$ et ouvert durant la période (T - ).

L'axe horizontal est l'axe des temps t. Le signal de commande VSE est un signal impulsionnel pouvant prendre deux états arbitraires "0" et "1" logiques.

Il faut que l'on puisse recopier l'information analogique aux bornes de la capacité $C_M$ en un temps inférieur à , ce qui conduit à la relation suivante:

$(R_s + r_i)C_M < \tau$

D'un autre côté, il faut que l'on puisse maintenir la tension analogique sans dégradation durant le temps (T -$\tau$), ce qui impose que l'on respecte la condition suivante :

$I_E (T - \tau) = C\Delta V$ avec $\Delta V < V$, V étant la tension analogique mémorisée et $\Delta V$ représentant la perte de l'information aux bornes de C pendant l'intervalle de temps (T - $\tau$).

On peut se fixer comme éléments de calcul les données typiques suivantes:

- fréquence d'échantillonnage: 8 MHz environ, d'où T = 125 ns
- durée d'échantillonnage: $\tau$ = 25 ns d'où T - $\tau$ = 100 ns

On peut dès lors analyser le comportement du pont de diodes SCHOTTKY pour acquérir le signal vidéo.

Pour l'acquisition du signal vidéo, on peut considérer deux cas.

Selon le premier cas, la tension transmise à la borne d'entrée $e_E$ passe d'une valeur $V_1$ à une valeur $V_2$ avec $V_1 < V_2$.

Si l'on se replace dans les conditions d'un circuit réel à pont de diodes SCHOTTKY, la figure 7 illustre schématiquement ce cas de fonctionnement.

La tension à la borne de sortie $S_E$ mémorisée par la capacité $C_M$ est égale à $V_1$ avant échantillonnage et la tension à échantillonner est égale à $V_2$ avec $V_1 < V_2$.

La capacité $C_M$ va se charger à courant constant. Ce courant constant $I_1$ est fourni par la conduction de la

diode $D_4$.

Il transite de la même façon dans la diode $D_2$ un courant $I_2$ qui est absorbé par les circuits de commande de l'échantillonneur qui seront décrits ultérieurement. Ce courant est fourni par l'amplificateur $A_1$.

La capacité $C_M$ va ainsi se charger jusqu'à ce que la tension atteigne la valeur $V_2$.

L'égalité des tensions aux bornes $e_E$ et $S_E$ provoque le passage en conduction des quatre diodes $D_1$ à $D_4$.

Le courant $I_1$ va se répartir dans les diodes $D_1$ et $D_4$, tandis que le courant $I_2$ proviendra de la somme des courants traversant respectivement les diodes $D_2$ et $D_3$. Le condensateur $C_M$ ne reçoit aucune autre charge additionnelle car les deux courants $I_1$ et $I_2$ sont égaux, les tensions des bornes $e_E$ et $S_E$ étant identiques. De même, l'amplificateur d'entrée $A_1$ ne délivre plus de courant vers le pont de diodes.

Le deuxième cas à considérer est la condition inverse selon laquelle la tension transmise à la borne d'entrée passe de la valeur $V_1$ à la valeur $V_2$, mais cette fois avec $V_1$ $V_2$.

Il faut pouvoir dans ce cas décharger la capacité mémoire $C_M$ de telle sorte que la tension à ses bornes puisse passer de $V_1$ à $V_2$ avec $V_2 < V_1$.

La décharge de la capacité $C_M$ est obtenue par la mise en conduction des diodes $D_3$ et $D_1$. Dans ce cas, l'amplificateur d'attaque du pont de diodes doit être capable d'absorber le courant $I_1$.

D'un autre côté, la capacité $C_M$ va se décharger avec le courant constant $I_2$. Cette décharge du condensateur $C_M$ va durer tant que l'on n'aura pas égalité entre les tensions présentes aux bornes $e_E$ et $S_E$.

On assiste, dès lors que cette égalité est obtenue, à la conduction des diodes $D_2$ et $D_4$ de sorte que l'on arrête la décharge de la capacité $C_M$. On se retrouve ainsi avec la même situation que pour le premier cas : conduction simultanée des diodes $D_1$ à $D_4$, et annulation des courants de l'amplificateur d'entrée et du condensateur $C_M$.

En résumé, le pont associé à des circuits de commande peut se représenter suivant le schéma illustré par la figure 8.

En effet, les circuits de commande de l'échantillonneur-bloqueur peuvent être représentés sous la forme d'un schéma équivalent comprenant deux sources de tension VE et VF de résistances internes respectives R' et R'' en parallèle sur une source de courant constant $I_3$.

A l'équilibre, une tension de valeur V en sortie $SA_1$ de l'amplificateur $A_1$ est recopiée aux bornes du condensateur $C_M$.

A la conduction du pont de diodes $D_1$ à $D_4$, un courant $I_1$ circule dans la résistance R' et les deux branches du pont de diodes, $D_1$ - $D_2$, d'une part, $D_4$ - $D_3$, d'autre part.

Ce courant est fourni par un générateur de tension $V_E$.

Ce courant obéit à la relation:

$$I_1 = \frac{V_E - VC_1}{R'} \quad \text{avec } VC_1 - V = V_d \, ;$$

relation dans laquelle $V_d$ est la tension directe de conduction d'une diode et V la tension en sortie de l'amplificateur $A_1$.

Un courant $I_2$ circule également dans la résistance R'', fourni par le générateur de tension $V_F$. Le courant obéit à la relation:

$$I_2 = \frac{V_F - VD_1}{R''} \quad \text{avec } V - VD_1 = V_d$$

Les deux courants $I_1$ et $I_2$ sont additionnés dans une source de courant $I_3$, telle que la relation suivante soit satisfaite:

$I_3 = I_1 + I_2$

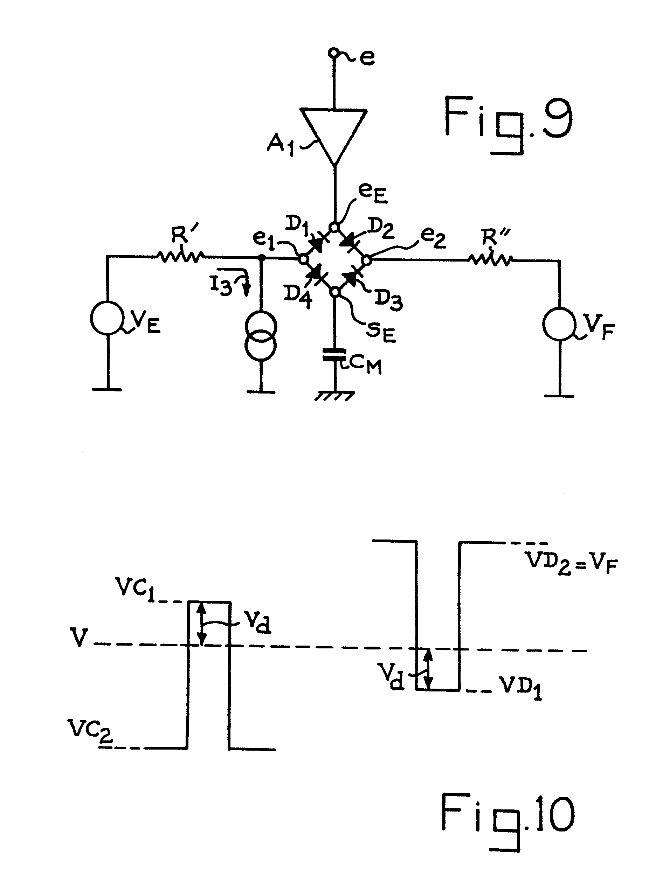

Au blocage du pont de diodes, comme représenté sur la figure 9, la source de courant $I_3$ est commutée à la borne $e_1$, le courant $I_3$ circule alors dans R', et la tension devient :

$VC_2 = V_E - (R' \times I_3)$

Cette tension, inférieure à V, provoque le blocage des diodes $D_1$ et $D_4$. La tension $V_F$ étant supérieure à la tension V, les diodes $D_2$ et $D_3$ sont bloquées, aucun courant ne circule dans la résistance R''. La tension de la borne $e_2$ est égale à $VD_2 = V_F$.

La figure 10 représente le diagramme des tensions $VC_1$, $VD_1$, $VC_2$ et $VD_2$, à la conduction et au blocage du pont de diodes, par rapport au niveau de la tension V. On remarque sur ce diagramme que la tension V, c'est-à-dire la tension sur la borne d'entrée $e_E$ peut évoluer entre les valeurs $VC_2$ et $VD_2$, pendant le blocage des diodes: la différence $VD_2$ - $VC_2$ représente l'amplitude maximale des tensions parasites pouvant être éliminées par le circuit d'échantillonnage.

On remarque également que l'amplitude des impulsions aux bornes $e_1$ et $e_2$ dépend de la valeur de la tension V de sortie de l'amplificateur $A_1$: si V croît, l'amplitude de l'impulsion à la borne $e_1$ croît, et celle de l'impulsion à la borne $e_2$ diminue; si V diminue, l'inverse se produit.

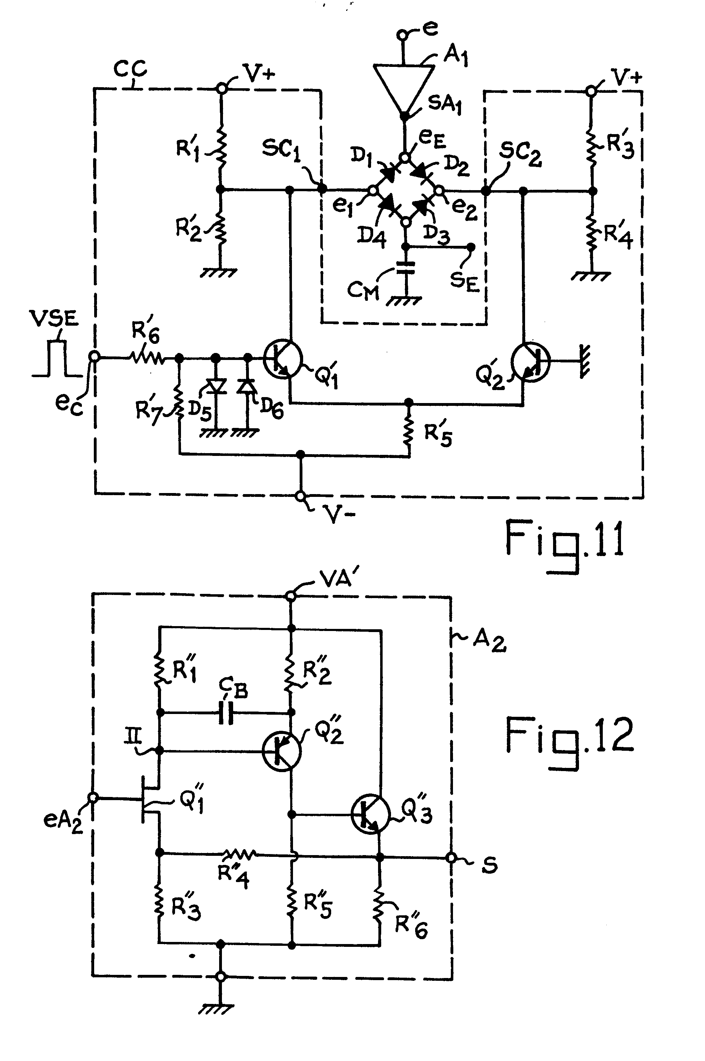

On va maintenant décrire un exemple de réalisation pratique des circuits de commande de l'échantillonneur-bloqueur conforme à l'invention permettant d'obtenir le fonctionnement qui vient d'être explicité. Un tel exemple de réalisation des circuits de commande CC est représenté sur la figure 11.

Les sources de tension $V_E$ et $V_F$, les résistances de source R' et R", la source de courant $I_3$ des figures 9 et 10, et la commutation de cette sources entre les bornes $e_1$ et $e_2$ sont réalisées par deux ponts de résistances $R'_1$ - $R'_2$ et $R'_3$ - $R'_4$ associés à deux transistors bipolaires $Q'_1$ et $Q'_2$ de type NPN constituant un amplificateur différentiel à liaisons directes. Les circuits sont alimentés par une double source d'alimentation en tension, fournissant les tensions V+ et V- par rapport au potentiel de la terre.

Les ponts de résistances $R'_1$ - $R'_2$ et $R'_3$ - $R'_4$ sont disposés entre une borne d'alimentation au potentiel V+ et la terre.

Les points communs des résistances des ponts constituent les sorties $SC_1$ et $SC_2$ des circuits de commande et sont reliés aux bornes d'entrée $e_1$ et $e_2$ du pont de diodes. Ces points milieux sont également reliés aux collecteurs des transistors $Q'_1$ et $Q'_2$. Ceux-ci sont montés en émetteur commun relié à une borne d'alimentation, de potentiel V-, par une résistance $R'_5$.

La borne d'entrée $e_c$ des circuits de commande CC est associée à un pont de résistance $R'_6$ - $R'_7$ dont le point commun est connecté à la base du transistor $Q'_1$.

Entre cette base et la terre sont disposées en parallèle, têtebêche, deux diodes $D_5$ et $D_6$.

Enfin, la base du transistor $Q'_2$ est reliée à la terre.

La source de tension $V_E$ du schéma équivalent des figures 8 et 9 est constituée par la tension à vide du pont $R'_1$ - $R'_2$, soit:

$$V_E = V^+ \left( \frac{R'_2}{R'_1 + R'_2} \right)$$

avec une résistance interne équivalente

$$R' = \frac{R'_1 \, R'_2}{R'_1 + R'_2} \cdot$$

De la même manière, la source de tension $V_F$ est constituée par la tension à vide du pont $R'_3$ - $R'_4$ soit :

$$V_F = V^+ \left( \frac{R'_4}{R'_3 + R'_4} \right) \text{avec R''} = \frac{R'_3 \, R'_4}{R'_3 + R'_4} \cdot$$

La source de courant $I_3$ est réalisée par les transistors $Q'_1$ ou $Q'_2$, portés alternativement à la conduction par l'impulsion de commande appliquée sur la base de $Q_1$, la valeur du courant $I_3$ étant déterminée par la résistance $R_5$ tel que $I_3 = (V-)/R_5$. Le circuit de commande du transistor $Q'_1$, à partir d'une impulsion de commande VSE, par exemple présentant les niveaux logiques "TTL": $\simeq$ 0V, +4V, est donc constitué des résistances $R'_6$ et $R'_7$ et des diodes $D_5$ et $D_6$. Ce circuit permet de limiter l'excursion de tension sur la base du transistor $Q'_1$, afin:
- d'une part, d'augmenter la vitesse de commutation de l'amplificateur différentiel $Q'_1$ - $Q'_2$, et
- d'autre part, de contrôler la valeur du courant $I_3$ pendant la conduction de $Q'_1$ et de la rendre sensiblement égale à celle atteinte pendant la conduction de $Q'_2$.

Pour une valeur typique de tension de saturation de conduction des diodes égale à 0,7 Volts, on a:

$$a/ \quad IB_2 = \frac{V^- - 0,7}{R'_5}$$

$$b/ \quad IB_1 = \frac{V^-}{R'_5}$$

relations dans lesquelles $IB_1$ et $IB_2$ sont les courants de base respectifs des transistors $Q'_1$ et $Q'_2$.

Les circuits de commande du dispositif échantillonneur-bloqueur selon l'invention présentent donc les avantages suivants:
- Commande du pont de diodes par des niveaux continus bien définis (pas de liaison capacitive, ni selfique).
- Possibilité de maintien de longue durée.
- Temps d'acquisition très rapide, typiquement de l'ordre de 10 ns.
- Symétrie des deux circuits de commande: ce qui permet que les signaux parasites, générés par les impulsions de commande et injectés dans la capacité mémoire se neutrodynent et que l'on puisse minimiser ainsi les signaux parasites d'échantillonnage résiduel.

Enfin, d'un point de vue pratique, les circuits de commande CC de l'échantillonneur sont compatibles avec les circuits intégrés du commerce fournissant un signal logique, aux niveaux "TTL" par exemple ou a tout autre standard sans adaptation. Un tel circuit intégré sera utilisé pour générer le signal unique de commande VSE.

Enfin, si l'on se reporte à nouveau au synoptique général de l'échantillonneur-bloqueur représenté sur la figure 3, le dispositif selon l'invention comprend un amplificateur de sortie $A_2$ dont l'entrée est connectée à la borne $S_E$.

La figure 12 illustre un exemple de réalisation pratique d'un tel amplificateur.

Cet amplificateur est connecté à une source d'alimentation fournissant un potentiel VA' par rapport à la terre, qui peut être de façon préférentielle, par souci de simplification, le potentiel VA alimentant l'amplificateur $A_1$.

Dans l'exemple illustré, l'amplificateur $A_2$ comprend trois étages connectés en cascade comprenant chacun un transistor: $Q''_1$, $Q''_2$, $Q''_3$; les deux derniers étant des transistors bipolaires de type NPN et le premier, pour des raisons qui vont être explicitées, un transistor à effet de champ de type DMOS.

L'entrée $eA_2$ est connectée à l'électrode de commande du transistor $Q''_1$, celui-ci étant disposé en série entre une résistance $R''_1$ de charge reliée à la borne de potentiel VA' et une résistance $R''_3$ reliée à la terre.

Le point II de connexion entre le transistor $Q''_1$ et la résistance $R''_1$ est relié directement à la base du transistor $Q''_2$, de type PNP dont le collecteur est connecté à une résistance de charge $R''_5$, elle-même connectée à la terre. L'émetteur de ce transistor est relié à la borne d'alimentation de potentiel VA par une résistance $R''_2$.

Enfin, la base du transistor $Q''_3$ de l'étage de sortie, de type NPN, est reliée directement au collecteur du transistor $Q''_2$. Le collecteur du transistor $Q''_3$ est relié directement à la borne d'alimentation de potentiel VA' et son émetteur est relié, d'une part, à la borne de sortie S de l'amplificateur $A_2$ et, d'autre part, via une résistance $R''_6$, à la terre.

Un réseau de contre-réaction comprenant une résistance $R''_4$ est disposé entre le drain du transistor $Q''_1$ et l'émetteur du transistor $Q''_3$.

Les caractéristiques particulières demandées à l'amplificateur $A_2$ vont maintenant être précisées. Le courant d'entrée doit être très faible, afin de conserver l'information de la capacité de mémorisation $C_M$ (figure 1), le plus longtemps possible, sachant que la perte d'information $\Delta V_E$, aux bornes de cette capacité $C_M$ est égale à:

$$\Delta V_E = \frac{I_E \times \Delta t}{C_M}$$

avec $I_E$ le courant d'entrée du transistor $Q_1''$ et $\Delta t$ le temps d'interruption entre deux échantillons successifs.

Pour minimiser ce courant d'entrée, le transistor employé est de préférence un transistor à effet de champ, en technologie DMOS.

L'impédance de sortie doit également être faible, afin de réaliser l'interface avec un étage de restitution de la composante continue ou avec un câble coaxial.

L'impédance de sortie $Z_S$ de ce montage est donnée par la relation: $Z_S = R''_4 \beta_2 \beta_3$; relation dans laquelle $\beta_2$ est le gain en courant du transistor $Q''_2$ et $\beta_3$ est le gain en courant du transistor $Q''_3$

La bande passante doit être supérieure à la fréquence maximale contenue dans le signal échantillonné. Le contrôle de la bande passante est réalisé par une capacité $C_B$ disposée entre le point II et l'émetteur du transistor $Q''_2$.

En effet, la fréquence de coupure $f_c$ de cet amplificateur est égale à:

$$f_c = \frac{1}{2\pi\, C_B\, R_A}\, G_0$$

avec $R_A$ la résistance apparente au point II et $G_0$ le gain en boucle ouverte de l'amplificateur $A_2$.

L'invention n'est naturellement pas limitée aux seuls exemples de réalisation précisément décrits mais s'étend à toutes variantes à la portée de l'homme de métier.

Le dispositif échantillonneur-bloqueur à pont de diodes selon l'invention peut être associé à tout dispositif à transfert de charges, notamment lorsqu'il est nécessaire d'avoir un temps d'acquisition court, un temps de maintien long et un faible résidu d'échantillonnage, pour l'extraction des informations en sortie de ce type de dispositifs.

**Revendications**

1. Dispositif échantillonneur-bloqueur comprenant, connectés en cascade, un premier étage amplificateur ($A_1$) recevant un signal à échantillonner sur son entrée (e), un étage d'échantillonnage et de mémorisation analogique (CEM) du signal de sortie du premier étage amplificateur ($A_1$) et un second étage amplificateur ($A_2$), l'étage d'échantillonnage et de mémorisation analogique comprenant un pont de diodes ($D_1$ - $D_4$) comportant deux branches parallèles de diodes disposées tête-bêche, connectées entre une borne d'entrée ($e_E$) recevant le signal de sortie ($SA_1$) du premier étage amplificateur ($A_1$) et une borne de sortie ($S_E$) connectée d'une part, à l'entrée ($eA_2$) du deuxième étage amplificateur ($A_2$) et, d'autre part, à un organe de mémorisation analogique ($C_M$), caractérisé en ce qu'il comprend des circuits de commande d'échantillonnage (CC) à liaisons continues comprenant des premier et second générateurs de tension de même polarité reliés chacun, d'une part à des première et seconde bornes ($e_1$, $e_2$) constituées chacune par le point commun entre deux diodes tête-bêche de chacune des branches du pont et, d'autre part, à une borne commune à un potentiel de référence, un générateur de courant constant ($I_3$) et des moyens de commutation commandés par des signaux impulsionnels d'échantillonnage (VSE) présentant des premier et second niveaux, ces moyens de commutation connectant le générateur de courant constant ($I_3$) à la première borne du pont de diodes pendant un premier intervalle de temps ($\tau$), lorsque les signaux d'échantillonnage (VSE) sont au premier niveau et à la seconde borne dans le cas contraire, de manière à commander la conduction du pont de diodes ($D_1$-$D_4$) par des signaux impulsionnels complémentaires ($SC_1$, $SC_2$) et la recopie de l'amplitude des signaux présents sur la borne d'entrée ($e_E$) dans l'organe de mémorisation analogique ($C_M$) pendant le premier intervalle de temps ($\tau$).

2. Dispositif selon la revendication 1, caractérisé en ce que le potentiel de référence est le potentiel de la terre et en ce que les premier et second générateurs de tension sont constitués par une première source de tension constante (V+), dont un pôle est relié à la terre, et un diviseur à deux résistances ($R'_1$ - $R'_2$, $R'_3$ - $R'_4$) en série connectées entre l'autre pôle de la première source de tension (V+) et la terre, le point commun entre les résistances en série étant connecté à la première borne ($e_1$) pour le premier générateur et à la seconde borne ($e_2$) pour le second générateur.

3. Dispositif selon la revendication 2, caractérisé en ce que les moyens de commutation sont constitués par un amplificateur différentiel symétrique comprenant des premier ($Q'_1$) et second ($Q'_2$) transistors montés en émetteurs couplés, dont les collecteurs sont reliés respectivement aux première ($e_1$) et seconde ($e_2$) bornes du pont de diodes, la base du second transistor ($Q'_2$) étant reliée à la terre et la base du premier transistor ($Q'_1$) recevant les signaux périodiques d'échantillonnage et en ce que le générateur de courant constant est constitué par un circuit comprend une résistance ($R'_5$) et une seconde source de tension constante (V-) de polarité opposée à la première source de tension constante (V+), la résistance ($R'_5$) étant disposée entre les émetteurs des premier ($Q'_1$) et second ($Q'_2$) transistors et cette seconde source de tension constante (V-), de manière à ce qu'un courant ($I_3$) d'amplitude constante circule dans l'un ou l'autre des deux transistors de l'amplificateur différentiel selon l'état des signaux d'échantillonnage.

4. Dispositif selon l'une quelconque des revendications 1 à 3, caractérisé en ce que les diodes ($D_1D_4$) du pont sont des diodes SCHOTTKY.

5. Dispositif selon l'une quelconque des revendications 1 à 3, caractérisé en ce que l'organe de mémorisation analogique est un condensateur ($C_M$).

6. Dispositif selon la revendication 1, caractérisé en ce que l'amplificateur ($A_1$) du premier étage est un amplificateur différentiel à transistors montés en émetteurs couplés à configuration super$\beta$, à impédance de sortie optimisée à l'impédance présentée par le pont de diodes ($D_1$-$D_4$).

7. Dispositif selon la revendication 1, caractérisé en ce que l'amplificateur ($A_2$) du second étage comporte un étage d'entrée à transistor à effet de champ en technologie "DMOS".

8. Dispositif selon l'une quelconque des revendications 1 à 7, caractérisé en ce que le signal à échantillonner est un signal délivré par un dispositif photo-sensible à transfert de charges.

9. Dispositif selon l'une quelconque des revendications 1 à 7, caractérisé en ce que le signal à échantillonner est un signal de type vidéo délivré par un dispositif photo-sensible à transfert de charges formant la rétine d'une caméra de télévision.

9

Fig.1

Fig.2

Fig.3

Fig.4

Fig.5

Fig.6

Fig.7

Fig.8

Fig.9

Fig.10

Fig.11

Fig.12

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| A | GB-A-1 400 544 (WESTERN ELECTRIC CO. INC.) <br> * Page 3, ligne 11 - page 4, ligne 34 * | 1,5 | G 11 C 27/02 <br> H 04 N 3/15 |
| A | IEEE JOURNAL OF SOLID-STATE CIRCUITS, vol. SC-13, no. 6, décembre 1978, pages 864-873, IEEE, New York, US; G. ERDI et al.: "A precision FET-less sample-and-hold with high charge-to-droop current ratio" <br> * Page 865, colonne de gauche, ligne 18 - page 866, colonne de gauche, ligne 6 * | 1,5,6 | |
| A | REVIEW OF SCIENTIFIC INSTRUMENTS, vol. 44, no. 6, juin 1973, pages 712-714, American Institute of Physics; H.A. BALDIS et al.: "High speed single event sampler" <br> * Page 712, colonne de droite, lignes 1-16; figure 2 * | 1,2,5 | |
| A | RADIO FERNSEHEN ELEKTRONIK, vol. 32, no. 7, juillet 1983, pages 449-450, Berlin-Est, DD; W.G. BROVKOV: "Schnelle und genaue Abtast- und Halteschaltung" <br> * Page 449, colonne de droite, ligne 4- page 450, colonne de droite, ligne 8 * | 1,4,5 | |

DOMAINES TECHNIQUES RECHERCHES (Int. Cl.4)

G 11 C 27/02
H 04 N 3/15

---  -/-

Le présent rapport de recherche a été établi pour toutes les revendications

| Lieu de la recherche <br> LA HAYE | Date d'achèvement de la recherche <br> 01-12-1986 | Examinateur <br> BEQUET T.P. |
|---|---|---|

| | DOCUMENTS CONSIDERES COMME PERTINENTS | | Page 2 |

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 518 921 (LOGAN) | | |
| | --- | | |
| A | US-A-4 000 418 (WALDRON) | | |
| | ----- | | |

DOMAINES TECHNIQUES
RECHERCHES (Int. Cl.4)

Le présent rapport de recherche a été établi pour toutes les revendications

| Lieu de la recherche | Date d'achèvement de la recherche | Examinateur |
|---|---|---|
| LA HAYE | 01-12-1986 | BEQUET T.P. |